(19) Europäisches Patentamt
European Patent Office
Office européen des brevets

(11) Publication number: **0 184 402**
**B1**

(12) **EUROPEAN PATENT SPECIFICATION**

(45) Date of publication of patent specification: **14.11.90**

(51) Int. Cl.$^5$: **H 03 K 17/04,** H 03 K 17/56

(21) Application number: **85308722.9**

(22) Date of filing: **29.11.85**

(54) **A driver circuit.**

(30) Priority: **29.11.84 JP 253286/84**

(43) Date of publication of application:
**11.06.86 Bulletin 86/24**

(45) Publication of the grant of the patent:
**14.11.90 Bulletin 90/46**

(84) Designated Contracting States:
**DE FR GB**

(56) References cited:
**DD-A- 216 832**
**DE-A-2 910 889**

**ELEKTRONIK, VOL. 31, NO. 20, 8TH OCTOBER 1982, PAGES 71-75; MUNICH; B.R. PELLY "LEISTUNGSHALBLEITER - EIN ÜBERBLICK"**

(73) Proprietor: **MITSUBISHI DENKI KABUSHIKI KAISHA**
**2-3, Marunouchi 2-chome Chiyoda-ku**
**Tokyo 100 (JP)**

(72) Inventor: **Mori, Satoshi c/o Mitsubishi Denki K.K.**
**Kitaitami Seisakusho No. 1 Mizuhara 4-chome**
**Itami-shi Hyogo-ken (JP)**
Inventor: **Majumdar, Gourab c/o Mitsubishi Denki K.K.**
**Kitaitami Seisakusho No. 1 Mizuhara 4-chome**
**Itami-shi Hyogo-ken (JP)**

(74) Representative: **Beresford, Keith Denis Lewis et al**
**BERESFORD & Co. 2-5 Warwick Court High Holborn**
**London WC1R 5DJ (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 184 402 B1

## Description

Field of the invention

The present invention relates to a driver circuit, especially to that for driving a switching element.

Background of the invention

A prior art switching element such as a high power bipolar transistor conducts a switching operation in response to a signal from a driver circuit.

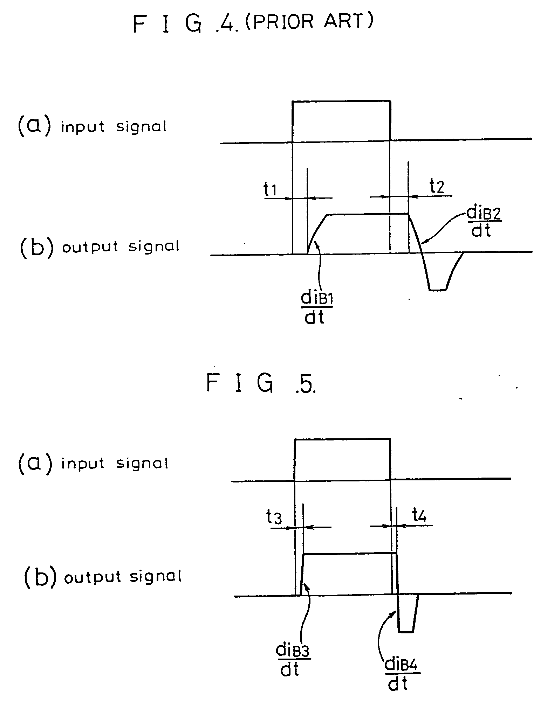

Figure 4 and Figure 5 show waveforms of an input and output signals in a prior art driver circuit and in an ideal driver circuit, respectively.

As apparent from the comparison between the waveforms shown in Figure 4 and 5, the delay times $t_1$, $t_2$ in responses of the output signal (refer to Figure 4 (b)) against the input signal (refer to Figure 4(a)) in the prior art driver circuit are both longer than those of the ideal case ($t_1>t_3$, $t_2>t_4$), and the rate of the rising up of the output signal $di_{B1}/dt$ and the rate of falling down of the output signal $di_{B2}/dt$ are both smaller than those of the ideal case

$$((di_{B1}/dt)<(di_{B3}/dt),\ (di_{B2}/dt)<(di_{B4}/dt)).$$

Furthermore, the time for a bias current to be converted into a reverse bias current is also long.

Another prior art driver circuit is disclosed in an article "Switching Phenomena and Base Drive Design" by Tinus Van de Wouw, Philips Semiconductors, PCI Proceedings, 1981. In this article it is disclosed "for a fast turn-on . . ., the base current should rise faster than the collector current", "A Darlington has a special property that the input transistor in fact desaturates the output transistor . . .", and "if the input transistor is overdriven too much, a tail in the turn-off appears . . . This tail is caused by the driver".

The pre-characterising features of claim 1 are known from DE—A—2910889. In the driver circuit of this document, the output signal has a high level, while the driven transistor is required to be "on", and an undershoot following the high level at the time when the driven transistor is required to be "off". In order to provide this output signal, first and second circuit portions receive separate first and second input signals, one to generate the high level and the other to generate the undershoot, and the input signals must be provided with the correct relative timing.

Summary of the invention

According to the present invention there is provided a driver circuit for driving a switching element in response to a bi-level input signal from an input signal generator, said driver circuit comprises:

an electrical isolation circuit for generating a signal electrically isolated from the bi-level input signal in response to the bi-level input signal;

a first circuit means which generates a first signal;

a second circuit means which receives the electrically isolated signal, and provides a second signal synchronous with the electrically isolated signal;

a third circuit means which receives the first signal from the first circuit means, and provides a third signal synchronous with the first signal; and

output circuitry which receives the signals from the second and third circuit means, and provides an output signal for driving said switching element in accordance with the sum of the levels of the second and third signal,

whereby the switching element is maintained in a conductive state, while the electrically isolated signal is at a first level, consequent on the output signal being provided by the output circuitry in accordance with the second signal, and the switching element is rendered non-conductive consequent on a turn-off pulse being provided in the output signal by the output circuitry in accordance with a pulse in the third signal, characterised in that

the first circuit means also receives the electrically isolated signal, and in response to a change in level of the dielectrically isolated signal from the first level to a second level the first signal changes level in a first direction and subsequently changes level in a second direction opposite to the first to form a pulse, and the third circuit means provides the said pulse in the third signal synchronously with the said pulse in the first signal, so that the said turn-off pulse is provided in the output signal in response to the said change in level of the electrically isolated signal,

and in that the output circuitry includes a MOSFET.

It is an objective of the present invention to provide a driver circuit having good responsiveness in the rising up and falling down of the output signal.

Another objective of the present invention is to provide a driver circuit capable of making the output current a constant level.

A further objective of the present invention is to provide a driver circuit capable of interfacing with TTL logic.

An embodiment of the present invention, given by way of non-limiting example, will now be described with reference to the accompanying drawings.

Brief description of the drawings

Figure 1 is a block diagram of a driver circuit as one embodiment of the present invention;

Figure 2 is a diagram showing signal waveforms appearing at each portions of the circuit of Figure 1;

Figure 3 is a circuit diagram having a detailed construction of the circuit of Figure 1;

Figure 4 is a diagram showing waveforms of the input and output signals in a prior art driver circuit; and

Figure 5 is a diagram showing waveforms of the input and output signals in an ideal driver circuit.

Detailed description of the preferred embodiments

In order to explain the present invention in detail, reference will be particularly made to Figures 1 and 2:

A driver circuit as one embodiment of the present invention is constituted by an electrical isolation circuit 51, a reverse current pulse generator 52, a positive current pulse generator 53, a negative current pulse generator 54, and an output stage circuit 55 which is constituted by MOSFETs. The electrical isolation circuit 51 is intended to receive the input signal 1, and to generate an output signal which is electrically isolated from the input signal by wave-reforming the input signal. The reverse current pulse generator 52 is intended to receive the output signal from the electrical isolation circuit 51, and to generate a signal falling down to a negative level from the 0 level in synchronisity with the falling down of the output signal. The positive current pulse generator 53 is intended to generate a rising up signal and a falling down signal in response to the rising up and falling down of the signal from the electrical isolation circuit 51. The negative current pulse generator 54 is intended to generate a signal falling down from 0 level in response to the falling down of the signal from the reverse current pulse generator 52. The output stage circuit 55 constituted by MOSFETs is intended to receive the signals from the positive current pulse generator 53 and the negative current pulse generator 54, and to generate a signal for driving a switching element 7.

In the driver circuit under such a construction, the output signal thereof is a signal obtained by the high speed operation of the MOSFETs, whereby the ideal waveform of the output signal shown in Figure 5 can be easily obtained.

Figure 3 shows an example of circuit construction of the driver circuit of Figure 1:

At first, the electrical isolation circuit 51 is constituted by a series connection of a photo-coupler 9 and a resistor 8 for restricting the current at the input portion of the photo-coupler 9.

The reverse current pulse generator 52 is constituted by a monostable multi-vibrator 10 provided with resistors 11 and 12 and a condenser 13. The photo-coupler 9 and the monostable multi-vibrator 10 are driven by the voltage from a power supply 2.

The positive current pulse generator 53 is constituted by an NPN transistor 16 which is turned on or off with receiving the signal from the photo-coupler 9 at the base thereof, and a PNP transistor 23 which is turned on or off synchronously with the turning on or off of the NPN transistor 16. The collector of the NPN transistor 16 is connected to a power supply 3 through resistors 19 and 20, and the emitter of the PNP transistor 23 is directly connected to the power supply 3.

The negative current pulse generator 54 is constituted by a PNP transistor 17 which is turned on or off with receiving the signal from the monostable multi-vibrator 10 at the base thereof through the constant voltage diode 14 which is connected to the multi-vibrator 10 in a reverse direction, and an NPN transistor 24 which is turned on or off synchronously with the turning on or off of the PNP transistor 17. The collector of the PNP transistor 17 is connected to a power supply 4 through resistors 21 and 22, and the emitter of the NPN transistor 24 is directly connected to the power supply 4. Both of the emitters of the NPN transistor 16 and of the PNP transistor 17 are connected to the ground, and the collectors of the PNP transistor 23 and of the NPN transistor 24 are connected to each other through a resistor 25, thereby to generate a signal for producing a signal for driving the switching element 7.

The output stage circuit 55 is constituted by an N channel MOSFET 26 and a P channel MOSFET 27 complementarily connected with each other which are turned on or off with receiving the signals from the positive and the negative current pulse generators 53 and 52 at the gates thereof, respectively. A positive voltage is applied to the drain of the N channel MOSFET 26 by a power supply 6, and a negative voltage is applied to the drain of the P channel MOSFET 27 by a power supply 5. The sources of the MOSFETs 26 and 27 are connected with each other to produce an output terminal.

The circuit of Figure 3 is operated as follows:

Firstly, the operation of turning on the switching element 7 which is typically constituted by an NPN power transistor is described. In response to the rising up of the input signal 1, a signal which is obtained by removing electrical noises from the input signal and which rises up in response to the rising up of the input signal is output from the photo-coupler 9. The NPN transistor 16 is turned on by the rising up of the signal from the photo-coupler 9 as a trigger signal. The PNP transistor 23 is turned on by the transition of the NPN transistor 16 to the on-state as a trigger signal. Then, a signal of 0 level is output from the monostable multi-vibrator 10 and the PNP transistor 17 is in an off-state. Accordingly, the NPN transistor 24 is also in an off-state. As a result, a voltage signal which comes from the power supply 3 through the PNP transistor 23 and the resistor 25 is applied to the gates of the MOSFETs 26 and 27. The N channel MOSFET 26 is turned on, and the P channel MOSFET 27 is turned off because the signal applied to the gates is a signal of positive voltage. Accordingly, a positive base current amplified by the loop constituted by the power supply 6, the N channel MOSFET 26, the base-emitter path of the switching transistor 7, and the power supply 6 is supplied to the switching element 7, whereby the element 7 is turned on synchronously with the on-state of the MOSFET 26.

At next, the operation of turning off the switching element 7 is described. The monostable multivibrator 10 receives the signal from the photocoupler 9 which falls down in response to the falling down of the input signal 1, and generates a

signal falling down from 0 level to a negative level triggered by the falling down of the input signal. The PNP transistor 17 is turned on in response to the falling down of the signal (it should be taken into consideration such as the storage time of the transistor 16). By this turning on of the PNP transistor 17, the NPN transistor 24 is turned on. Then, the transistors 16 and 23 are in off-states. Accordingly, a signal of negative level in accordance with the signal from the monostable multivibrator 10 is applied to the gates of the MOSFETs 26 and 27, whereby the MOSFET 26 is turned off and the MOSFET 27 is turned on. As a result, a current flows through the loop constituted by the power supply 5, the emitter-base path of the switching element 7, and the MOSFET 27, and a base reverse bias current is applied to the switching element 7, thereby turning off the switching element 7 at a high speed.

On the other hand, as apparent from the above description, the NPN transistor 16 and the PNP transistor 17 are not in on-states at the same time similarly as the PNP transistor 23 and the NPN transistor 24, and the N channel MOSFET 26 and the P channel MOSFET 27 are not in on-states at the same time. That is, when the transistors 16, 23 and the MOSFET 26 are in on-states, the transistors 17, 24 and the MOSFET 27 are surely in off-states and vice versa. Furthermore, when the input signal 1 is not given, the transistors 16, 17, 23, 24 and the MOSFETs 26, 27 are all in off-states.

In this way, it is obtained an ideal signal for driving a switching element which has no delay against the input signal.

As evident from the foregoing, in the illustrated embodiment, MOSFETs are used at the final stage of the driver circuit, thereby enabling to reduce the delay time of the output signal against the input signal to a great extent, and to be interfaced by TTL logic. When this circuit is constituted by a hybrid IC, this effect becomes marked.

Furthermore, the rising up and falling down of the base current as a driving signal given to the switching element becomes quite sharp, thereby obtaining an ideal signal as one for driving a switching element such as a power transistor.

Accordingly, the switching time for the switching element is reduced to a great extent, thereby reducing the switching loss to a great extent.

Furthermore, MOSFETs are used at the final stage of the driver circuit, whereby the total power loss of the driver circuit becomes small, and the capacity of the power supply for the driver circuit can be reduced to a great extent.

**Claims**

1. A driver circuit for driving a switching element (7) in response to a bi-level input signal (1) from an input signal generator, said driver circuit comprises:

an electrical isolation circuit (51) for generating a signal electrically isolated from the bi-level input signal in response to the bi-level input signal;

a first circuit means (52) which generates a first signal;

a second circuit means (53) which receives the electrically isolated signal, and provides a second signal synchronous with the electrically isolated signal;

a third circuit means (54) which receives the first signal from the first circuit means, and provides a third signal synchronous with the first signal; and

output circuitry (55) which receives the signals from the second and third circuit means, and provides an output signal for driving said switching element (7) in accordance with the sum of the levels of the second and third signal,

whereby the switching element (7) is maintained in a conductive state, while the electrically isolated signal is at a first level, consequent on the output signal being provided by the output circuitry (55) in accordance with the second signal, and the switching element (7) is rendered nonconductive consequent on a turn-off pulse being provided in the output signal by the output circuitry (55) in accordance with a pulse in the third signal, characterised in that

the first circuit means (52) also receives the electrically isolated signal, and in response to a change in level of the electrically isolated signal from the first level to a second level the first signal changes level in a first direction and subsequently changes level in a second direction opposite to the first to form a pulse, and the third circuit means provides the said pulse in the third signal synchronously with the said pulse in the first signal, so that the said turn-off pulse is provided in the output signal in response to the said change in level of the electrically isolated signal,

and in that the output circuitry (55) includes a MOSFET.

2. A driver circuit as defined in claim 1, wherein the first circuit means comprises a monostable multi-vibrator.

3. A driver circuit as defined in claim 1 or claim 2, wherein the second and third circuit means comprise a PNP transistor (23) and an NPN transistor (24), respectively.

4. A driver circuit as defined in claim 3 wherein the PNP transistor (23) and the NPN transistor (24) are coupled collector-to-collector by the output circuitry (55).

5. A driver circuit as defined in any one of the preceding claims wherein the output circuitry (55) comprises two metal oxide semiconductor field effect transistors (26, 27) complementarily connected with each other.

6. A driver circuit as defined in claim 5 wherein the gates of the field effect transistors are connected together and receive the sum of the second and third signals.

**Patentansprüche**

1. Treiberschaltung für ein Schaltelement (7) entsprechend einem von einem Eingangssignalgenerator gelieferten Eingangssignal (1) mit zwei

Pegeln mit:

einer elektrischen Trennschaltung (51) zur Erzeugung eines elektrisch vom Zwei-Pegel-Eingangssignal getrennten Signal als Antwort auf das Zwei-Pegel-Eingangssignal;

einem ersten Schaltkreis (52) zur Generierung eines ersten Signals;

einem zweiten, mit dem elektrisch getrennten Signal beaufschlagten Schaltkreis, der synchron zum elektrisch getrennten Signal ein zweites Signal liefert;

einem mit dem ersten Signal vom ersten Schaltkreis beaufschlagten dritten Schaltkreis (54), der synchron zum ersten Signal ein drittes Signal bereitstellt; und

einem Ausgangsschaltkreis (55), der durch die Signale vom zweiten und dritten Schaltkreis beaufschlagt ist und ein Treiber-Ausgangssignal für das Schaltelement (7) entsprechend der Summe der Pegel des zweiten und dritten Signals abgibt,

wobei das Schaltelement (7) in leitendem Zustand gehalten wird, während des elektrisch getrennte Signal auf einem ersten Pegel steht, und daraus folgend das Ausgangssignal des Ausgangsschaltkreises (55) in Übereinstimmung mit dem zweiten Signal ist, während das Schaltelement (7) in den nichtleitenden Zustand versetzt wird als Folge eines Abschalt-Pulses im Ausgangssignal des Ausgangsschaltkreises (55) entsprechend einem Puls im dritten Signal, dadurch gekennzeichnet, daß

der erste Schaltkreis (52) ebenfalls durch das elektrisch getrennte Signal beaufschlagt wird, als Antwort auf einen Pegelwechsel des elektrisch getrennten Signals vom ersten zum zweiten Pegel das erste Signal seinen Pegel in einer ersten Richtung und anschließend in einer entgegengesetzten zweiten Richtung wechselt zur Bildung eines Pulses, und der dritte Schaltkreis den Puls im dritten Signal synchron mit dem Puls im ersten Signal liefert, so daß der Abschalt-Puls im Ausgangssignal als Antwort auf den Pegelwechsel des elektrisch getrennten Signals erscheint, und daß

der Ausgangsschaltkreis (55) einen MOSFET enthält.

2. Treiberschaltung nach Anspruch 1, bei der der erste Schaltkreis einen monostabilen Multivibrator enthält.

3. Treiberschaltung nach Anspruch 1 oder Anspruch 2, bei dem der zweite und dritte Schaltkreis einen PNP-Transistor (23) bzw. einen NPN-Transistor (24) enthält.

4. Treiberschaltung nach Anspruch 3, bei der der PNP-Transistor (23) und der NPN-Transistor (24) durch den Ausgangsschaltkreis (55) kollektorseitig verbunden sind.

5. Treiberschaltung nach einem der vorstehenden Ansprüche, bei der der Ausgangssschaltkreis (55) zwei komplementär verbundene Metalloxid-Halbleiter-Feldeffekttransistoren (26, 27) enthält.

6. Treiberschaltung nach Anspruch 5, bei der die Gates der Feldeffekttransistoren durchverbunden und mit der Summe von zweitem und dritten Signal beaufschlagt sind.

**Revendications**

1. Un circuit d'attaque prévu pour attaquer un élément de commutation (7) sous la dépendence d'un signal d'entrée à deux niveaux (1), provenant d'un générateur de signal d'entrée, ce circuit d'attaque comprenant:

un circuit d'isolation électrique (51) qui est destiné à produire un signal électriquement isolé par rapport au signal d'entrée à deux niveaux, sous la dépendance du signal d'entrée à deux niveaux;

un premier circuit (52) qui produit un premier signal;

un second circuit (53) qui reçoit le signal électriquement isolé, et qui produit un second signal en synchronisme avec le signal électriquement isolé;

un troisième circuit (54) qui reçoit le premier signal provenant du premier circuit, et qui produit un troisième signal en synchronisme avec le premier signal; et

un circuit de sortie (55) qui reçoit les signaux provenant des second et troisième circuits, et qui produit un signal de sortie pour attaquer l'élément de commutation (7) conformement à la somme des niveaux des second et troisième signaux,

grâce à quoi l'élément de commutation (7) est maintenu dans un état conducteur, pendant que le signal électriquement isolé est à un premier niveau, sous l'effet du signal de sortie qui est fourni par le circuit de sortie (55) conformément au second signal, et l'élément de commutation (7) est bloqué sous l'effet d'une impulsion de blocage qui est produite dans le signal de sortie, par le circuit de sortie (55), conformément à une impulsion dans le troisième signal, caractérisé en ce que

le premier circuit (52) reçoit également le signal électriquement isolé et, sous l'effet d'un changement de niveau du signal électriquement isolé, passant du premier niveau à un second niveau, le premier signal change de niveau dans une première direction, et il change ensuite de niveau dans une seconde direction opposée à la première, pour former une impulsion, et le troisième circuit produit l'impulsion précitée dans le troisième signal en synchronisme avec l'impulsion précitée dans le premier signal, de façon que l'impulsion de blocage soit produite dans le signal de sortie sous l'effet du changement précité du niveau du signal électriquement isolé.

et en ce que le circuit de sortie (55) comprend un transistor MOS à effet de champ.

2. Un circuit d'attaque selon la revendication 1, dans lequel le premier circuit comprend un multivibrateur monostable.

3. Un circuit d'attaque selon la revendication 1 ou la revendication 2, dans lequel les second et troisième circuits comprennent respectivement un transistor PNP (23) et un transistor NPN (24).

4. Un circuit d'attaque selon la revendication 3, dans lequel le transistor PNP (23) et le transistor

NPN (24) sont couplés collecteur à collecteur par le circuit de sortie (55).

5. Un circuit d'attaque selon l'une quelconque des revendications précédentes, dans lequel le circuit de sortie (55) comprend deux transistors à effet de champ métal-oxyde-semiconducteur (26, 27) qui sont connectés de façon mutuellement complémentaire.

6. Un circuit d'attaque selon la revendication 5, dans lequel les grilles des transistors à effet de champ sont connectées ensemble et elles reçoivent la somme des second et troisième signaux.

FIG. 1.

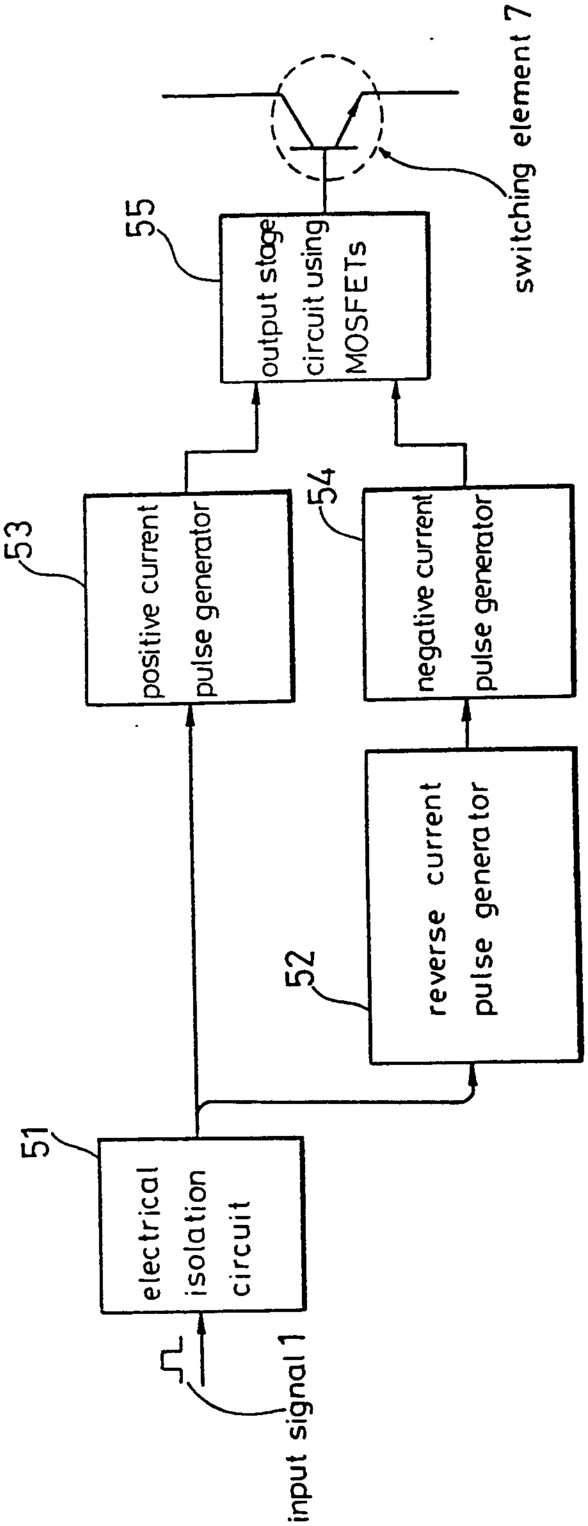
input signal 1
electrical isolation circuit
51
reverse current pulse generator
52
positive current pulse generator
53
negative current pulse generator
54
output stage circuit using MOSFETs
55
switching element 7

FIG. 2.

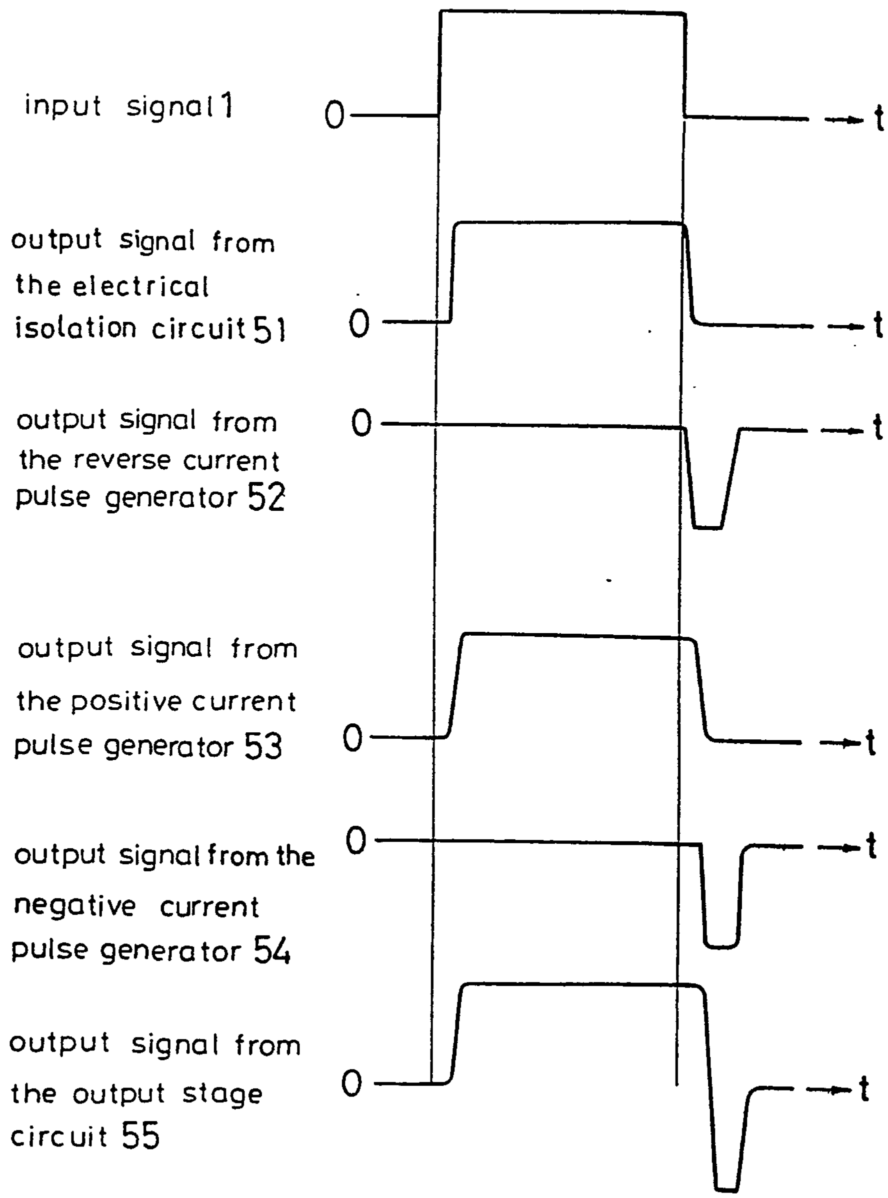
input signal 1
0
t
output signal from the electrical isolation circuit 51
0
t
output signal from the reverse current pulse generator 52
0
t
output signal from the positive current pulse generator 53
0
t
output signal from the negative current pulse generator 54
0
t
output signal from the output stage circuit 55
0
t

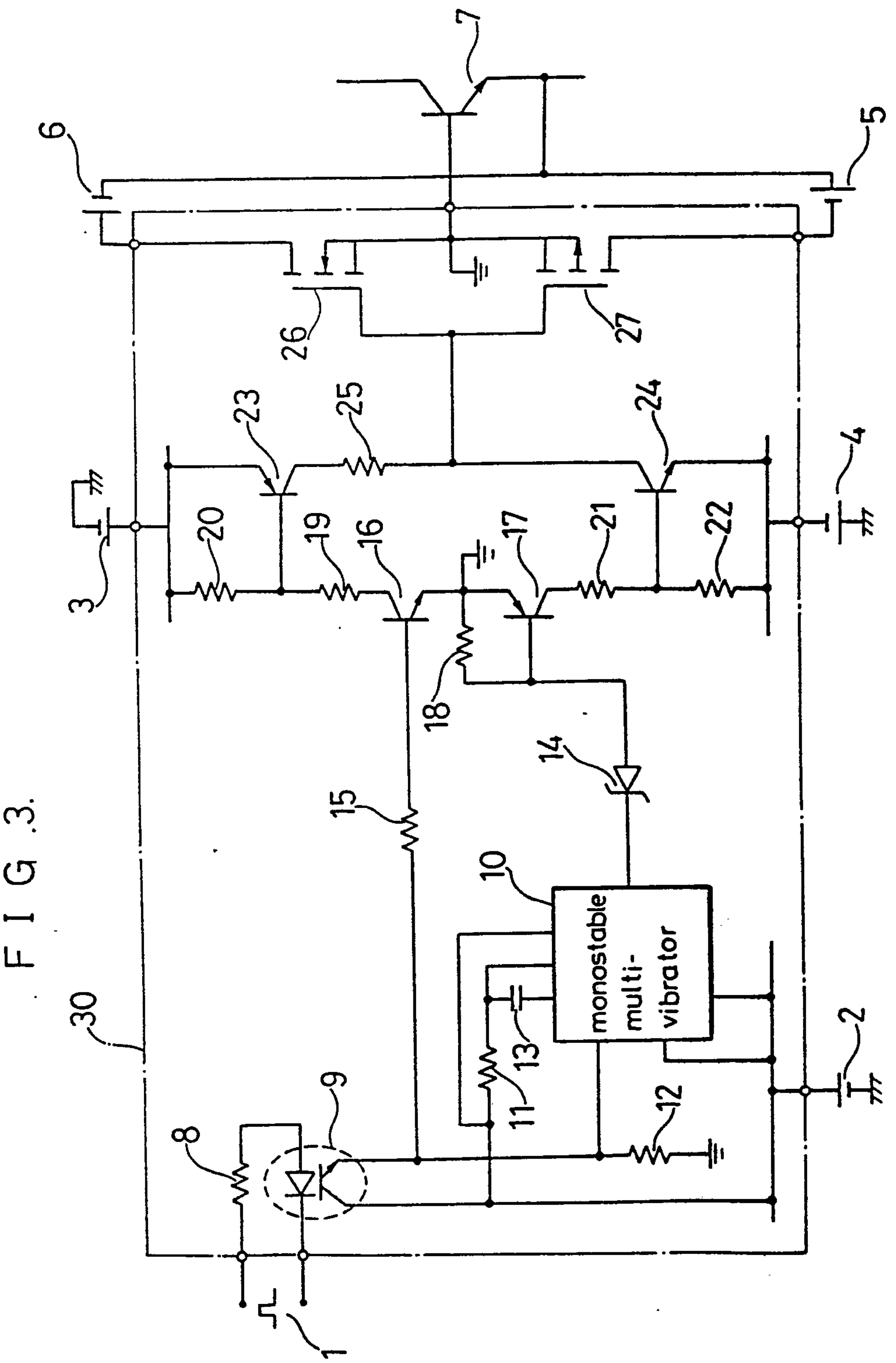

monostable multi-vibrator
1
2
3
4
5
6
7
8
9
10
11
12
13
14
15
16
17
18
19
20
21
22
23
24
25
26
27
30


F I G .3.

F I G .4. (PRIOR ART)

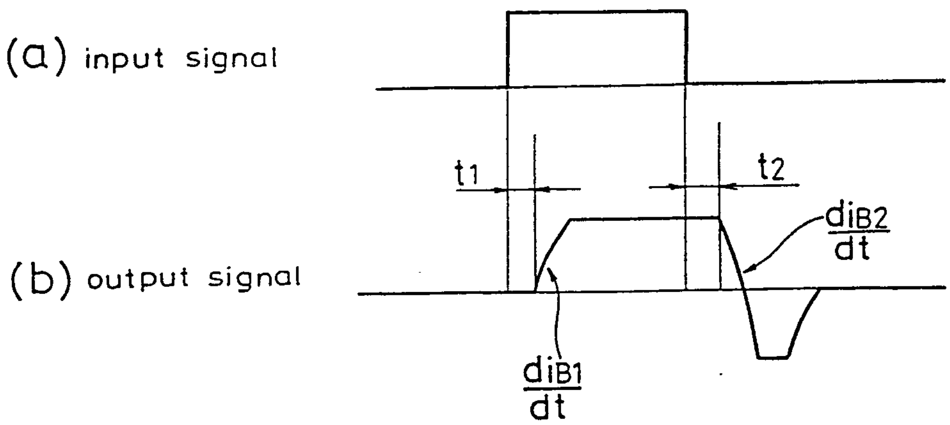


F I G .5.